Europäisches Patentamt

European Patent Office

Office européen des brevets

(11) Publication number: **0 091 806**
**B1**

(12) **EUROPEAN PATENT SPECIFICATION**

(45) Date of publication of patent specification: **17.01.90**

(51) Int. Cl.⁵: **H 01 L 21/268**

(21) Application number: **83302004.3**

(22) Date of filing: **08.04.83**

(54) A method for producing a single crystalline semiconductor layer.

(30) Priority: **09.04.82 JP 59249/82**

(43) Date of publication of application:
**19.10.83 Bulletin 83/42**

(45) Publication of the grant of the patent:
**17.01.90 Bulletin 90/03**

(84) Designated Contracting States:
**DE FR GB**

(56) References cited:
**EP-A-0 071 471**
**DE-C- 970 859**

**PATENTS ABSTRACTS OF JAPAN, vol. 5, no.
145 (E-74)817r, 12th September 1981; & JP - A -
56 80 138 (CHO LSI GIJUTSU KENKYU KUMIAI)
01-07-1981**

(73) Proprietor: **FUJITSU LIMITED**
**1015, Kamikodanaka Nakahara-ku
Kawasaki-shi Kanagawa 211 (JP)**

(72) Inventor: **Sakurai, Junji**
**7-11, Seta 4-chome
Setagaya-ku Tokyo 158 (JP)**

(74) Representative: **Fane, Christopher Robin King
et al
HASELTINE LAKE & CO. Hazlitt House 28
Southampton Buildings Chancery Lane
London, WC2A 1AT (GB)**

EP 0 091 806 B1

## Description

The present invention relates to a method for producing a single-crystalline semiconductor layer, for example for use in a semiconductor device.

Semiconductor devices having a silicon-on-insulating-substrate (SOIS) structure have become a focus of attention in the art as they are suitable for forming elements with high density and facilitate high-speed element operation.

In a semiconductor device having an SOIS structure, nonsingle-crystalline silicon formed on an insulating layer or other insulating substrate is single-crystallized by being melted. Then, an element having a transistor, resistance, or other function is formed on the single-crystallized silicon layer.

In the process for single-crystallization of the nonsingle-crystalline silicon layer, a beam irradiation process is often used. The conventional method, however, has problems with the quality of the obtained single-crystalline silicon layers, which problems tend to limit both the electrical properties and production yield of semiconductor devices formed on the single-crystalline silicon layers.

An embodiment of the present invention can provide a method for producing a semiconductor device comprising the steps of: preparing a base body; forming a nonsingle-crystalline semiconductor layer on said base body; and irradiating said nonsingle-crystalline semiconductor layer with an energy beam having a strip shaped irradiation region in such a manner that either one of said base body or said energy beam is moved in a direction other than a scanning direction of said energy beam.

Such an embodiment can be carried out so as to provide an improved heat-treatment method of single crystallization as compared with a prior art method.

Reference will now be made, by way of example, to the accompanying drawings, in which:

Figs. 1A and 1B are a schematic top plan view, for explanation of a prior method, and a cross-sectional view of Fig. 1A respectively;

Fig. 2 is a schematic view of a conventional state of single crystallization;

Figs. 3A and 3B are a schematic top plan view for explanation of an embodiment of the invention and a cross-sectional view of Fig. 3A, respectively;

Fig. 4 is a schematic view of a process for heat treatment of a polycrystalline silicon layer using a main heater and an additional heater;

Fig. 5 is a schematic cross-sectional view of a process for heating a polycrystalline silicon layer by a lamp;

Fig. 6 is a cross-sectional view of an example of a slit plate for use in a method embodying the invention;

Fig. 7 is a schematic cross-sectional view for explanation of oscillation apparatus for use in a method embodying the present invention; and

Fig. 8 is a cross-sectional view of an example of a semiconductor device produced by an embodiment of the present invention.

Before describing the preferred embodiments, a discussion will be made of the conventional method and its attendant problems. From DE-C-970589 and JP-A-5680138 a method of crystallizing a semiconductor layer is known in which a strip shaped energy beam is scanned over said layer.

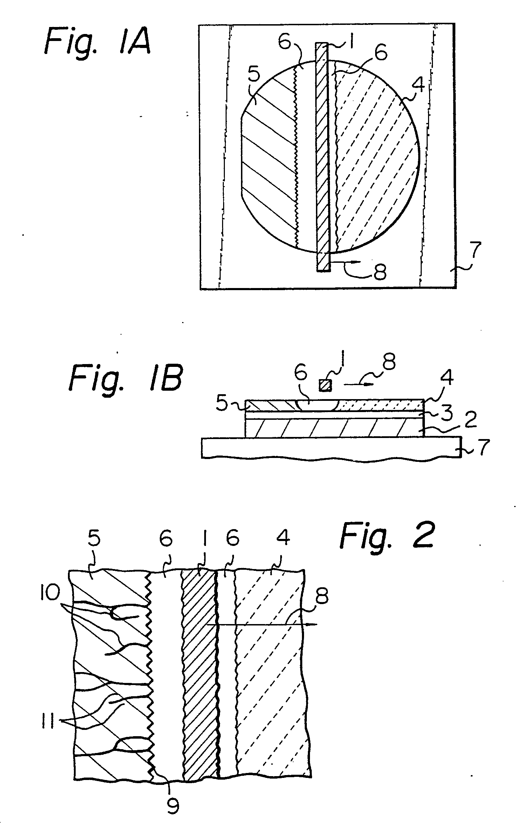

Figures 1A and 1B schematically show a conventional infrared ray heating process in which a nonsingle-crystalline silicon layer is changed to a single-crystalline silicon layer.

As shown in Figs. 1A and 1B, a carbon strip heater 1 which has a strip shaped irradiation region and is heated to a temperature from 1500°C to 1600°C is supported near the upper surface of a polycrystalline silicon layer 4 formed on, for example, a silicon dioxide layer 3 on a silicon substrate 2. The silicon substrate 2 or the carbon heater 1 is moved transversely with respect to the axis of the carbon strip heater 1. A band shaped infrared ray beam irradiated from the carbon heater 1 is scanned from a portion of the polycrystalline silicon layer 4 to the direction marked by reference numeral 8 to gradually melt the polycrystalline silicon layer 4. The melted silicon liquid 6 is recrystallized to form a single-crystallized silicon layer 5. A preliminary heater 7 is to heat the silicon substrate 2 and the polycrystalline silicon layer 4 uniformly.

If the carbon strip heater 1 gives off an uneven temperature or if it has even slight unevenness on its surface, a boundary surface 9 between the melted silicon liquid 6 and the single-crystalline layer 5 becomes zig-zag in form, as shown in Fig. 2. This results in the formation of small angle grain-boundaries 10 and twin crystal regions 11 at a plurality of the uneven points. This affects the quality of the obtained single crystalline silicon layer and, therefore, the electrical properties and production yield of the semiconductor device using the single-crystalline silicon layer as an element forming substrate.

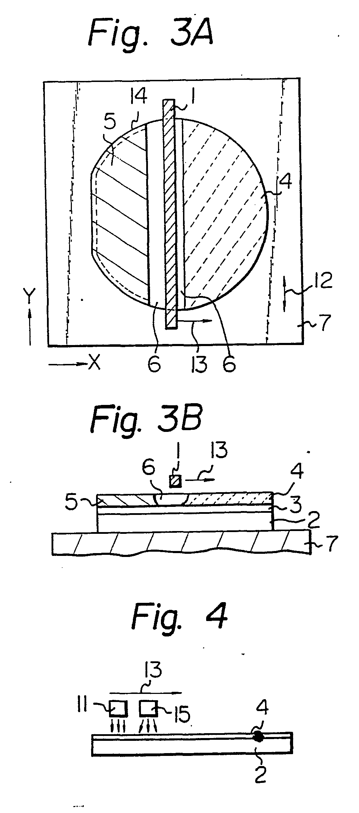

Referring to Figs. 3A and 3B in an embodiment of the invention, a substrate to be treated is horizontally mounted on a heated XY stage 7. A silicon dioxide (SiO$_2$) insulating layer 3 having a thickness of approximately 1 to 2 μm (microns) is formed on a silicon substrate 2. A polycrystalline silicon layer 4 is formed by chemical vapor deposition on the silicon dioxide insulating layer 3. A bar-shaped carbon heater 1 heated to a temperature of 1500°C to 1600°C is supported at a position 1 mm from the upper surface of the substrate to be treated, i.e., the surface of the initial polycrystalline silicon layer 4.

A band-shaped infrared ray beam from the bar-shaped carbon heater 1 is scanned in the X axial direction at a speed of approximately 1 mm per second on the polycrystalline silicon layer 4 to melt the layer 4 and recrystallize it to form a single-crystallized silicon layer 5.

During the scanning, the substrate to be treated and the carbon heater 1 are relatively oscillated in the direction Y of the carbon heater 1 at a frequency of 1 KHz and an amplitude of 1 mm. It is preferable that the oscillating speed be larger than at least 10 times the beam scanning speed. Further it is preferable that the amplitude of the oscillation range from 50 µm to 50 mm. For the oscillation and scanning, either the substrate or the carbon heater 1 may be moved.

The repeated movement of the beam over the same surface portion of the polycrystalline silicon layer 4 by the relative oscillation 12 between the carbon heater 1 and the substrate acts against any unevenness of the temperature of the carbon heater 1 or unevenness of the surface of the carbon heater 1 to produce a uniform temperature distribution in the silicon liquid 6. This results in an improved single-crystallized silicon layer 5, as regards the occurence of small -angle grain-boundaries or twin crystal regions, everywhere except for a circumferential edge portion 14 where grain boundaries are formed.

As shown in Fig. 4 in an embodiment of the present invention, two carbon strip heaters 11 and 15 may be used in place of a single carbon heater 1. An additional carbon heater 15 preliminarily heats a region, adjacent to where a main carbon strip heater 11 is capable of uniform heating, at a temperature a little lower than the melting point of silicon. Provision of the additional carbon strip heater 15 in front of the main carbon strip heater 11 increases the uniform heating effect of the main carbon strip heater 11 on the polycrystalline silicon layer 4. In the figure, the arrow mark 13 shows the scanning direction.

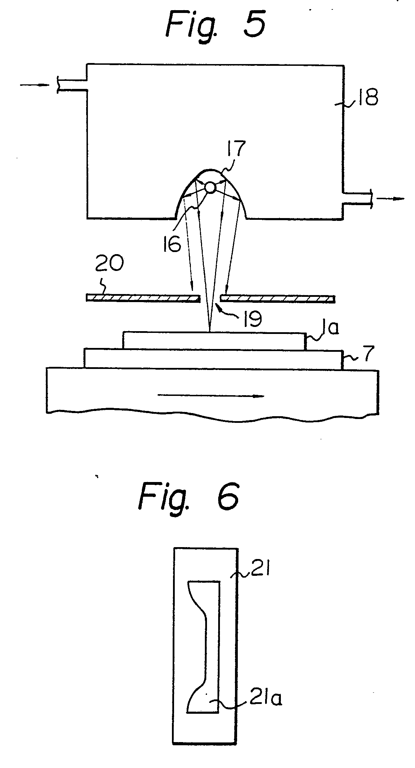

It is preferable that the polycrystalline silicon layer 4 be heated in such a manner that the center surface of the polycrystalline silicon is cooled earlier than the circumference of the polycrystalline silicon. Such a heating process allows the single crystallization to occur from the center portion to the circumference of the polycrystalline silicon layer 4. This enables an entirely uniform single-crystallized silicon layer across the silicon wafer to be obtained. Such a method is known per se from EP-A-0071471. A tungsten lamp may be used in place of a carbon strip heater, as shown in Fig. 5. A beam irradiated from the tungsten lamp 16 is reflected by a mirror 17 made of gold-plated aluminum or the like to heat a silicon wafer 1a on a preliminary heated stage 7 through a bar-shaped slit formed in a slit plate 20. The mirror 17 is cooled by a water tank 18. The arrow mark shows the flow of water.

In the above heating process, the slit plate 20 may be replaced by a slit plate 21 having a slit 21a, as shown in Fig. 6. The slit plate 21 enables heating of the wafer including the polycrystalline silicon layer to be carried out in such a manner that center portion of the wafer is cooled earlier than the circumferential portion, again resulting in entirely uniform single-crystallization.

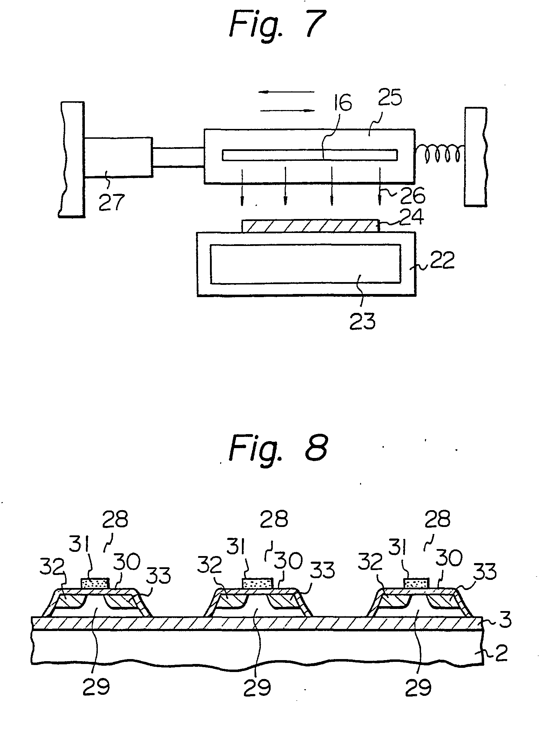

Figure 7 shows an example of an oscillating device for use in embodiments of the invention. In this case, the heater is a tungsten lamp 16 provided in a lamp chamber 25. The chamber 25 is oscillated by an ultrasonic vibrator 27. The beam 26 from the lamp 16 therefore oscillates when irradiating a wafer 24 positioned on a hot stage 22 heated by a heater 23.

The process of forming a semiconductor, e.g., one having metal oxide semiconductor (MOS) transistors, after forming the single-crystallized layer, is shown in Fig. 8. Boron ions, for example, are implanted to the single-crystallized silicon layer 29 formed on the silicon dioxide layer 3 on single-crystalline silicon wafer 2 and annealed to form a P-type single-crystallized silicon layer 29. Then, a plurality of mesa-type silicon islands 28, comprising the P-type single-crystallized silicon layer, are formed by separating the P-type single-crystallized silicon layer into a plurality of regions by either a well-known etching or selective oxidation process. Then, gate oxidation film 30 is formed on the silicon islands 28 by a thermal oxidation process or the like. After that, polycrystalline silicon gate electrodes 31 are formed on the gate oxidation film 30 by a Chemical Vapor Deposition process and etching process. Arsenic ions are then selectively implanted to the $P_-$ type single crystallized layer using the silicon gate 31 as a masking film. After that, the implanted portion is annealed to obtain $N_+$ type source regions 32 and $N_+$ type drain regions 33. Thus, after metalization and passivation, a semiconductor IC of an SOIS structure having a MOS transistor can be completed.

It will be appreciated that each of the above-described embodiments of the invention provides a method of producing a crystalline semiconductor layer, comprising the steps of:

forming an initial semiconductor layer on a substrate;

causing radiated energy to be incident on the semiconductor layer over a region thereof that is elongate in form and extends longitudinally completely across that layer; and

bringing about relative motion, between the said layer and means whereby the said radiated energy is directed onto that layer, in a scanning direction transverse to the longitudinal dimension of the said region so as to cause the said region to scan over the said layer thereby to bring about conversion of the layer to substantially single-crystalline semiconductor material;

wherein continuous auxiliary motion transverse to the said scanning direction is superimposed on the said relative motion so as to improve uniformity of recrystallization of the semiconductor layer as the said region passes over it. The radiated energy beam may be provided, for example, by an infrared ray beam, a visible ray beam or an ultraviolet ray beam.

**Claims**

1. A method of producing a semiconductor device comprising the steps of:

preparing a base body;

forming a nonsingle-crystalline semiconductor layer on said base body; and

irradiating said nonsingle-crystalline semiconductor layer with an energy beam having a strip shaped irradiation region in such a manner that either one of said base body or said energy beam is moved in a direction other than the scanning direction of said energy beam.

2. A method according to claim 1, wherein said energy beam is transversely oscillated with reference to said scanning direction of said energy beam.

3. A method according to claim 2, wherein the amplitude of said oscillation of said energy beam ranges from 50 μm to 5 mm.

4. A method according to claim 1, wherein said energy beam is selected from a group comprising an infrared ray beam, a visible ray beam, and an ultraviolet ray beam.

5. A method of producing a crystalline semiconductor layer, comprising the steps of:

forming an initial semiconductor layer on a substrate;

causing radiated energy to be incident on the semiconductor layer over a region thereof that is elongate in form and extends longitudinally completely across that layer; and

bringing about relative motion, between the said layer and means whereby the said radiated energy is directed onto that layer, in a scanning direction transverse to the longitudial dimension of the said region so as to cause the said region to scan over the said layer thereby to bring about conversion of the layer to substantially single-crystalline semiconductor material;

characterized in that continuous auxiliary motion transverse to the said scanning direction is superimposed on the said relative motion so as to improve uniformity of recrystallization of the semiconductorlayer as the said region passes over it.

6. A method as claimed in claim 5 wherein the said continuous auxiliary motion is an oscillatory motion.

7. A method as claimed in claim 5 or 6 wherein the said continuous auxiliary motion is substantially parallel to the semiconductor layer.

**Patentansprüche**

1. Verfahren zur Herstellung einer Halbleitervorrichtung mit den folgenden Schritten:

Präparieren eines Basiskörpers;

Bilden einer nicht einkristallinen Halbleiterschicht auf dem genannten Basiskörper;

Bestrahlen der genannten nicht einkristallinen Halbleiterschicht mit einem Energiestrahl, der einen streifenförmigen Bestrahlungsbereich hat, derart, daß einer von beiden, der Basiskörper oder der Energiestrahl, in einer anderen Richtung als der Überstreichrichtung des Energiestrahls bewegt wird.

2. Verfahren nach Anspruch 1, bei dem der genannte Energiestrahl in Bezug auf die genannte Abtastrichtung des genannten Energiestrahls transversal oszilliert wird.

3. Verfahren nach Anspruch 2, bei dem die Amplitude der genannten Oszillation des genannten Energiestrahls im Bereich von 50 μm bis 5 mm liegt.

4. Verfahren nach Anspruch 1, bei dem der genannte Energiestrahl aus einer Gruppe ausgewählt wird, die einen infraroten Strahl, einen sichtbaren Strahl und einen ultravioletten Strahl umfaßt.

5. Verfahren zur Herstellung einer kristallinen Halbleiterschicht, mit den folgenden Schritten:

Bilden einer anfänglichen Halbleiterschicht auf einem Substrat;

Bewirken, daß die abgestrahlte Energie auf die Halbleiterschicht auf einen Bereich davon auftrifft, der eine längliche Form hat und sich längsweise vollständig quer zu jener Schicht erstreckt; und

Herbeiführen einer relativen Bewegung, zwischen der genannten Schicht und der Einrichtung, wodurch die abgestrahlte Energie auf jene Schicht gerichtet wird, in einer Überstreichrichtung quer zu der Längsdimension des genannten Bereiches, um so zu bewirken, daß der genannte Bereich über die genannte Schicht streicht und dadurch eine Umwandlung der Schicht in im wesentlichen einkristallines Halbleitermaterial herbeizuführen;

dadurch gekennzeichnet, daß eine kontinuierliche Hilfsbewegung quer zu der genannten Überstreichrichtung der genannten relativen Bewegung überlagert wird, um so die Gleichförmigkeit der Rekristallinisation der Halbleiterschicht zu verbessern, während der genannte Bereich sich über sie bewegt.

6. Verfahren nach Anspruch 5, bei dem die genannte kontinuierliche Hilfsbewegung eine oszillierende Bewegung ist.

7. Verfahren nach Anspruch 5 oder 6, bei dem die genannte kontinuierliche Hilfsbewegung im wesentlichen parallel zu der Halbleiterschicht ist.

**Revendications**

1. Procédé de production d'un dispositif semiconducteur comportant les étapes consistant à:

préparer un corps de base:

former une couche semiconductrice non monocristalline sur ledit corps de base: et

irradier ladite couche semiconductrice non monocristalline avec un faisceau énergétique présentant une région d'irradiation en forme de ruban tout en déplaçant l'un ou l'autre, dudit corps de base ou dudit faisceau énergétique, selon une direction autre que la direction de balayage dudit faisceau énergétique.

2. Procédé selon la revendication 1, dans lequel on fait osciller ledit faisceau énergétique transversalement par rapport à ladite direction de balayage dudit faisceau énergétique.

3. Procédé selon la revendication 2, dans lequel l'amplitude de ladite oscillation dudit faisceau énergétique va de 50 μm à 5 mm.

4. Procédé selon la revendication 1, dans lequel on choisit ledit faisceau énergétique dans un groupe constitué d'un faisceau de rayons infrarouges, d'un faisceau de rayons visibles et d'un faisceau de rayons ultraviolets.

5. Procédé de production d'une couche semi-conductrice cristalline, comportant les étapes consistant à:

former une couche semiconductrice initiale sur un substrat;

faire en sorte qu'une énergie rayonnée tombe sur la couche semi-conductrice, sur une région de cette couche qui soit de forme allongée et s'étende longitudinalement complètement de part et d'autre de cette couche; et

faire effectuer un déplacement relatif entre ladite couche et les moyens par lesquels ladite énergie rayonnée est envoyée sur cette couche, selon une direction de balayage transversale à la dimension longitudinale de ladite région, de façon à faire en sorte que ladite région en vienne à balayer toute ladite couche, effectuant ainsi la conversion de la couche en un matériau semiconducteur substantiellement monocristallin;

caractérisé en ce que l'on superpose audit déplacement relatif un déplacement auxiliaire continu transversal à ladite direction de balayage de façon à améliorer l'uniformité de la recristallisation de la couche semiconductrice lorsque ladite région passe sur cette couche.

6. Procédé selon la revendication 5, dans lequel ledit déplacement auxiliaire continu est un mouvement oscillatoire.

7. Procédé selon la revendication 5 ou 6, dans lequel ledit déplacement auxiliaire continu est sensiblement parallèle à la couche semiconductrice.

*Fig. IA*

*Fig. IB*

*Fig. 2*

# Fig. 3A

# Fig. 3B

# Fig. 4

# Fig. 5

# Fig. 6

# Fig. 7

16  25

27  26

24

22

23

# Fig. 8

28  28  28

31  31  31
32  30  33  32  30  33  32  30  33

3

2

29  29  29